# EUROPEAN PATENT APPLICATION

(11) **EP 4 474 845 A1**
(43) Date of publication of application: **11.12.2024**
(21) Application number: 23178158.4
(22) Date of filing: 08.06.2023
(51) Int. Cl.: G01R 33/48, G01R 33/54, G01R 33/561, G01R 33/56, G01R 33/565

(54) **MR IMAGING USING PARTIAL FOURIER ACQUISITION**

(71) Applicant: Koninklijke Philips N.V., 5656 AG Eindhoven (NL)
(72) Inventor: EGGERS, Holger, Eindhoven (NL)
(74) Representative: Philips Intellectual Property & Standards

(57) **Abstract**

The invention relates to a method of MR imaging of an object (10) placed in an examination volume of an MR system (1). It is an object of the invention to provide a method that enables improved MR imaging using partial Fourier (PF) acquisition. According to the invention, MR signals are generated by subjecting the object (10) to an imaging sequence comprising readout magnetic field gradients and phase-encoding magnetic field gradients to sample a fraction of a pre-defined region of k-space corresponding to a field of view, wherein the sampled fraction is automatically selected based on prior information. The MR signals are acquired from the object (10) and an MR image is reconstructed exploiting conjugate symmetry of the MR signals in k-space. Moreover, the invention relates to an MR system (1) and to a computer program to be run on an MR system (1). The invention proposes to automatically tailor the asymmetric fractional coverage of the pre-defined k-space region to the expected distribution of the MR signal in k-space by exploiting any available prior knowledge.

## Description

### FIELD OF THE INVENTION

The invention relates to the field of magnetic resonance (MR) imaging. It concerns a method of MR imaging of an object placed in the examination volume of an MR system. The invention also relates to an MR system and to a computer program to be run on an MR system.

### BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

In MR imaging, so-called partial Fourier (PF) techniques are well known. These are acquisition and reconstruction methods in which MR signal data sampled from only a fraction of a k-space region that corresponds to a given field of view are used. These methods exploit the conjugate symmetry of the MR signal data in k-space to compensate for the missing data.

In theory, PF methods allow sampling of only one half of the pre-defined k-space region. The other half is synthesized in reconstruction under the assumption of conjugate symmetry, which only holds for real (as opposed to complex) MR signals in image space. In practice, MR signals in image space are hardly ever real. Reconstruction from MR signal data obtained by PF sampling by mere mirroring and conjugation, followed by a Fourier transform, is, therefore, not advisable. However, various algorithms have been developed to produce relatively artifact-free images based on the assumption that there is smooth phase variation across the MR image. Thus, although these methods do not simply fill in the missing data by complex conjugation, they still exploit the conjugate symmetry in the reconstruction with additional consideration of the phase variations. They typically require the sampling to be slightly extended to fully cover the central k-space region and thus to capture low-frequency phase variation.

Two types of PF imaging are used in common practice and are available as options on all major brands of MR systems. These are known generically as "phase conjugate symmetry" and "read conjugate symmetry". In the first case, only a fraction of the full k-space region is sampled in the phase-encoding direction, while k-space is fully sampled in the frequency-encoding direction. In the second case, only a fraction of the full k-space is sampled in the frequency-encoding direction, while k-space is fully sampled in the phase-encoding direction.

Fractional sampling of k-space along the readout (frequency-encoding) direction, is also referred to as partial echo (PE) acquisition. It is a well-known strategy for reducing the echo time (TE), see M. Bydder et al. in NMR in Biomedicine, 2021; 34:e4458. This is useful for acquiring MR signals from short T₂ species but also reduces the repetition time (TR) and, if applicable, the inter-echo spacing of the used imaging sequence. PE sampling is of particular interest in magnetic resonance angiography (MRA) to mitigate signal loss induced by flow.

PF methods are fundamentally limited by the missing k-space data, which prevent recovering the high-frequency phase variation in image space and may cause severe artifacts and/or signal loss. Acceleration methods, such as parallel imaging (PI) and compressed sensing (CS), are in general unable to compensate for this deficiency, mainly due to the large size of the continuous k-space region spared by the incomplete sampling.

### SUMMARY OF THE INVENTION

It is an object of the invention to provide a method that enables improved MR imaging using PF acquisition.

In accordance with the invention, a method of MR imaging of an object placed in an examination volume of an MR system is disclosed. The method comprises the following steps:
- generating MR signals by subjecting the object to an imaging sequence comprising readout magnetic field gradients and phase-encoding magnetic field gradients to sample a fraction of a pre-defined region of k-space corresponding to a field of view, wherein the sampled fraction is automatically selected based on prior information;
- acquiring the MR signals from the object; and
- reconstructing an MR image from the acquired MR signals exploiting conjugate symmetry of the MR signals in k-space.

The method of the invention employs the known principle of PF imaging, wherein k-space is sampled asymmetrically to enable exploitation of conjugate symmetry in the step of reconstructing the MR image. The invention proposes to automatically tailor the asymmetric fractional coverage of the pre-defined k-space region (which corresponds to the field of view to be imaged) to the expected distribution of the MR signal in k-space by exploiting any available prior knowledge. The selection aims at optimizing the reconstruction of high- frequency phase variations of the MR signal data in image space. The corresponding MR signal contributions are located in the more peripheral regions of k-space. The automatic selection may thus involve deriving an estimate of the distribution of the MR signals in k-space from the prior information.

The method of the invention can be used for both 2D and 3D acquisitions (with two phase-encoding directions).

In an embodiment of the invention, the automatic selection of the sampled fraction includes selection of one fully sampled half of the given k-space region either in one phase-encoding direction or in the readout direction. The selection may thus include the half of the pre-defined k-space region that is fully covered and/or the extent to which the other half of the pre-defined k-space region is covered. The sampled fraction is contiguous and covers less than 90%, preferably less than 80%, more preferably less than 70%, and yet more preferably less than 60% of the pre-defined k-space region, depending on the imaging task and the extent of phase variations.

In a possible embodiment, the MR signals are acquired as partial echoes. The automatic selection of the sampled fraction may include the selection of the partial echo factor determining the fraction of the full MR echo signal sampled in the readout direction. The desired echo time may be considered in this automatic selection as well.

In yet another embodiment, the direction of the readout magnetic field gradient is automatically selected based on the prior information to be either positive or negative. In the case of partial echo acquisition, the respective half of the pre-defined k-space region that is covered by the selected fraction determines the direction of the readout magnetic field gradient in either the positive or the negative direction. The direction of the readout magnetic field gradient, in turn, determines the direction of the fat shift. The latter may also be considered in the automatic selection of the sampled k-space fraction in order to obtain an optimum quality of the reconstructed MR image.

In a possible embodiment, the prior information comprises one or more of:
- at least one pre-recorded MR image of the object,
- at least one sensitivity map indicating the spatial sensitivity profile of an RF antenna used for reception of the MR signals, and
- a Bo map.

For example, strong spatial gradients in the Bo map indicate areas in image space where MR signals with high-frequency phase variations may occur in gradient echo imaging. Survey scans, coil sensitivity reference scans, and other pre-recorded MR images allow predicting from which areas MR signal contributions are to be expected at all, taking the potentially different contrasts of these scans into account. A coarse estimation of the signal distribution in the periphery of k-space can be obtained on this basis for any given imaging sequence. The selection of the fraction (half) of k-space to be covered fully by the sampling by the imaging sequence can be performed on this basis.

Coil sensitivity maps provide information on the shift of MR signal in k-space due to the spatial variation of the sensitivity of each individual RF antenna/coil used for reception of the MR signals. This can specifically be considered in the selection of the extent to which the other (incompletely sampled) half of the pre-defined k-space region is to be covered.

In a further embodiment, as in conventional PF imaging, a Bo map is taken into account (by a suitable algorithm) in the step of reconstructing the MR image to compensate for a spatially (smoothly) varying phase shift of the MR signals.

In 3D time of flight MRA, the acquisition often includes multiple adjacent three-dimensional sub-volumes (sometimes referred to as "chunks"), which are sampled in temporal succession. These 3D sub-volumes are then combined in the reconstruction step to produce one resulting 3D image. It can be beneficial to acquire MR signals from each "chunk" individually in accordance with the method of the invention and to perform the proposed selection of the k-space fraction for each 3D sub-volume individually and independently. This means, e.g., that the readout direction or the partial echo factor may change between the 3D sub-volumes.

The methods of the invention can be advantageously carried out on most MR systems in clinical use at present. To this end it is merely necessary to utilize a computer program by which the MR system is controlled such that it performs the above-explained method steps of the invention. The computer program may be present either on a data carrier or be present in a data network so as to be downloaded for installation in the control unit and/or reconstruction unit of the MR system.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows an MR system for carrying out the method of the invention;
Fig. 2 shows a diagram of k-space illustrating the automatic selection of the PF readout strategy according to the invention;
Fig. 3 shows MR images demonstrating the effect of a suitable selection of the sampled k-space fraction on image quality in PF imaging.

### DETAILED DESCRIPTION OF THE EMBODIMENTS

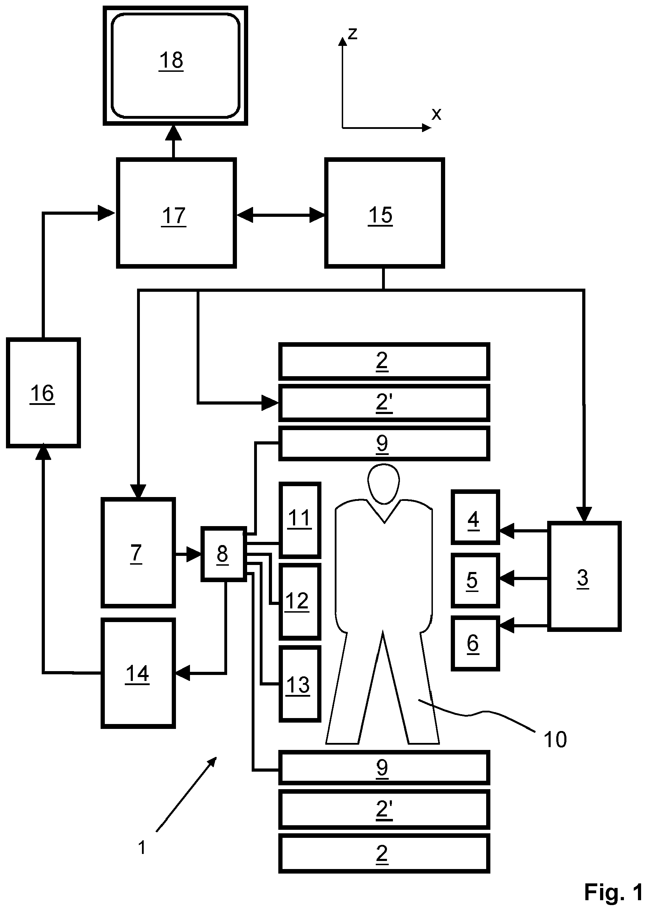

With reference to Fig. 1, an MR system 1 is shown as a block diagram. The system comprises superconducting or resistive main magnet coils 2 such that a substantially uniform, temporally constant main magnetic field Bo is created along a z-axis through an examination volume. The system further comprises a set of (1^{st}, 2^{nd}, and - where applicable - 3^{rd} order) shimming coils 2', wherein the current flow through the individual shimming coils of the set 2' is controllable for the purpose of minimizing Bo deviations within the examination volume.

A magnetic resonance generation and manipulation system applies a series of RF pulses and switched magnetic field gradients to invert, excite, refocus, and/or spatially and otherwise encode the magnetic resonance to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send/receive switch 8, to a RF body coil 9 to transmit RF pulses into the examination volume. A typical MR imaging sequence is composed of a packet of RF pulse segments of short duration which, together with any applied magnetic field gradients, achieve a selected manipulation of nuclear magnetic resonance. The RF pulses are used to manipulate magnetic resonance and select a portion of a body 10 positioned in the examination volume. The MR signals are also picked up by the RF body coil 9.

For generation of MR images of limited regions of the body 10, a set of local RF array coils 11, 12, 13 are placed contiguous to the region selected for imaging. The array coils 11, 12, 13 can be used to receive MR signals induced by transmissions of the RF body coil.

The resultant MR signals are picked up by the RF body coil 9 and/or by the RF array coils 11, 12, 13 and demodulated by a receiver 14 preferably including a preamplifier (not shown). The receiver 14 is connected to the RF coils 9, 11, 12 and 13 via the send/receive switch 8.

A host computer 15 controls the shimming coils 2' as well as the gradient pulse amplifier 3 and the transmitter 7 to generate the imaging sequences of the invention. For the selected sequence, the receiver 14 receives MR signal data from a single or a plurality of k-space lines in rapid succession following each RF excitation pulse. A data acquisition system 16 performs analog-to-digital conversion of the received signals and converts the MR data to a digital format suitable for further processing. In modern MR systems the data acquisition system 16 is a separate computer which is specialized in acquisition of raw image data.

Ultimately, the digital MR signal data are reconstructed into an image representation by a reconstruction processor 17 which applies a Fourier transform or other appropriate reconstruction algorithms, such as SENSE. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

The host computer 15 and the reconstruction processor 17 are arranged, by corresponding programming, to perform the method of the invention described herein above and in the following.

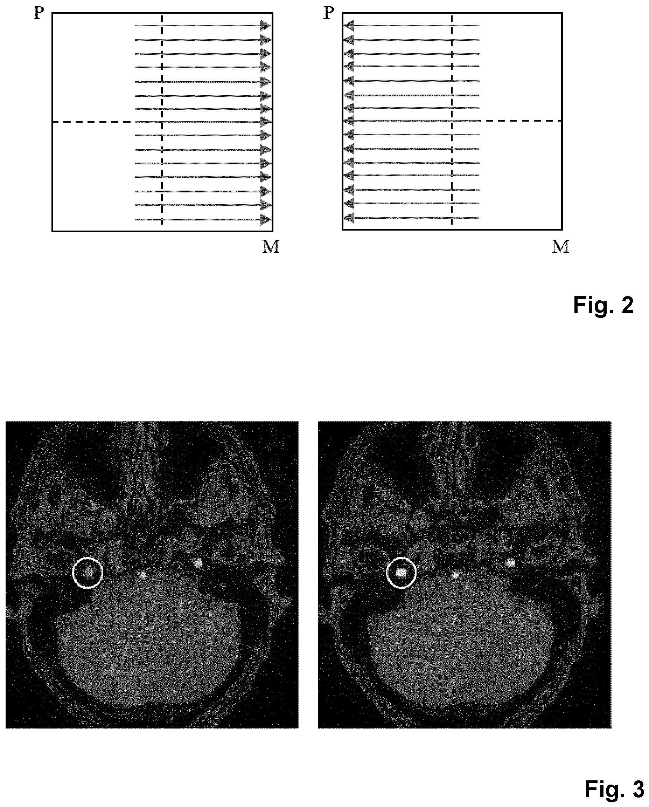

According to an embodiment of the invention, MR signals are acquired from the body 10 as partial echoes. Each partial echo represents a k-space line. This is illustrated in Fig. 2. In the depicted two-dimensional k-space diagrams the readout direction is indicated by M and the phase-encoding direction by P. As in conventional PE acquisitions, the peripheral parts of k-space are covered by the acquired k-space lines in one direction, but not in the opposite direction. A large continuous k-space area is thus spared. In the depicted two variants, either the positive or the negative half of the pre-defined k-space region (the latter indicated as the outlined square area) is fully covered. The area covered by the arrows (the k-space lines) is the fraction of the pre-defined k-space region that is automatically selected according to the invention. In the depicted embodiment, this selection includes the half of the k-space region that is fully covered (the right half in the left diagram or the left half in the right diagram) and the extent to which the other half of the k-space region is covered. In the embodiments shown in Fig. 2, a contiguous fraction of approximately 60% of the full k-space region is sampled. The selection is made automatically to avoid poor image quality due to high-frequency phase variations in image space.

Already the binary decision between the two variants shown in the diagrams of Fig. 2 (right or left k-space half fully covered) can have a profound impact on image quality as demonstrated in Fig. 3. The MR images of Fig. 3 show the corresponding results of cerebral MR angiography (MRA) using PE time-of-flight imaging. Especially the MR signal in the right internal carotid artery (white circles), seen on the left in the images in Fig. 3, is substantially decreased by the asymmetric coverage of k-space with the first variant compared to the second variant. Besides the selection of the half of the k-space region that is fully covered, the partial echo factor can also be adjusted in accordance with the expected MR signal distribution in k-space. In other cases, there may be more than two options, for instance in 3D PF imaging with two phase-encoding directions.

The automatic selection is based on prior information according to the invention. It is for example possible to learn the best choice of the fraction of k-space to be selected per anatomy to be imaged from sets of example MR images acquired from the respective anatomy. This can be automated, for example, by application of two different reconstructions to the same MR signal data (with different fractions of k-space used for the respective reconstructions), which are to a different degree sensitive to high-frequency phase variations. A subtraction of the resulting two images would then reveal whether there are any areas in the images that apparently suffer from lack of information on high-frequency phase content.

Also an adaptive selection is possible, in which a random selection is initially made and feedback is collected on the level of high-frequency phase artifacts in the resulting MR image. A modified selection can then be made accordingly in subsequent examinations.

Moreover, a patient-specific selection is conceivable using available information from prescans and/or a Bo map to estimate (simulate) the signal distribution in k-space for a specific PF acquisition.

In 3D time of flight MRA, the acquisition often includes multiple adjacent three-dimensional sub-volumes (sometimes referred to as "chunks"), which are sampled in temporal succession. These 3D sub-volumes are then combined in the reconstruction step to produce one resulting 3D image. It can be beneficial to acquire MR signals from each "chunk" individually in accordance with the method of the invention and to perform the proposed selection of the k-space fraction for each 3D sub-volume. This means that the readout direction or the partial echo factor may change between the 3D sub-volumes.

## Claims

1. Method of MR imaging of an object (10) placed in an examination volume of an MR system (1), the method comprising the steps of:
- generating MR signals by subjecting the object (10) to an imaging sequence comprising readout magnetic field gradients and phase-encoding magnetic field gradients to sample a fraction of a pre-defined region of k-space corresponding to a field of view, wherein the sampled fraction is automatically selected based on prior information;
- acquiring the MR signals from the object (10); and
- reconstructing an MR image from the acquired MR signals exploiting conjugate symmetry of the MR signals in k-space.

2. Method of claim 1, wherein the automatic selection of the sampled fraction includes selection of one fully sampled half of the given k-space region either in a phase-encoding direction or in the readout direction.

3. Method of claim 1 or 2, wherein the sampled fraction covers less than 90%, preferably less than 80%, more preferably less than 70%, and yet more preferably less than 60% of the pre-defined k-space region.

4. Method of any one of claims 1-3, wherein the MR signals are acquired as partial echoes.

5. Method of claim 4, wherein the automatic selection of the sampled fraction includes selection of the partial echo factor.

6. Method of claim 4 or 5, wherein the direction of the readout magnetic field gradient is automatically selected based on the prior information to be either positive or negative.

7. Method of any one of claims 1-6, wherein the prior information comprises one or more of:
- at least one pre-recorded MR image of the object (10),
- at least one sensitivity map indicating the spatial sensitivity profile of an RF antenna (9, 11, 12, 13) used for reception of the MR signals, and
- a Bo map.

8. Method of any one of claims 1-7, wherein the automatic selection involves deriving an estimate of the distribution of the MR signal in k-space from the prior information.

9. Method of any one of claims 1-8, wherein a Bo map is taken into account in the step of reconstructing the MR image to compensate for a spatially varying phase shift of the MR signals.

10. Method of any one of claims 1-9, wherein the MR signals are acquired from a three-dimensional volume divided into a number of sub-volumes, wherein the MR signals are acquired from each sub-volume individually, with the sampled fraction being selected independently for each sub-volume, and wherein the MR signals acquired in temporal succession from the individual sub-volumes are combined in the step of reconstructing the MR image.

11. MR system comprising:
- at least one main magnet coil (2) for generating a uniform, static magnetic field Bo within an examination volume,
- a number of gradient coils (4, 5, 6) for generating switched magnetic field gradients in different spatial directions within the examination volume,
- at least one RF coil (9) for generating RF pulses within the examination volume and/or for receiving MR signals from an object (10) positioned in the examination volume,
- a control unit (15) for controlling the temporal succession of RF pulses and switched magnetic field gradients, and
- a reconstruction unit (17) for reconstructing MR images from the received MR signals,
wherein the MR system (1) is configured to perform the following steps:
- generating MR signals by subjecting the object (10) to an imaging sequence comprising readout magnetic field gradients and phase-encoding magnetic field gradients to sample a fraction of a pre-defined region of k-space corresponding to a field of view, wherein the sampled fraction is automatically selected based on prior information;
- acquiring the MR signals from the object (10); and
- reconstructing an MR image from the acquired MR signals exploiting conjugate symmetry in image space.

12. Computer program comprising instructions to be executed by a computer, in particular a control unit (15) and/or a reconstruction unit (17) of an MR system (1), the execution of the instructions causing the computer to perform the following steps:
- automatically selecting, based on prior information, a fraction of a pre-defined region of k-space corresponding to a field of view;
- receiving MR signals sampled from the selected fraction; and
- reconstructing an MR image from the received MR signals exploiting conjugate symmetry in image space.
